# EUROPEAN PATENT APPLICATION

(11) **EP 2 400 332 A1**
(43) Date of publication of application: **28.12.2011**
(21) Application number: 09840435.3
(22) Date of filing: 11.12.2009
(51) Int. Cl.: G02B 7/02, H04N 5/225, H04N 5/335

(54) **LENS UNIT, ALIGNING METHOD, IMAGE PICKUP DEVICE AND METHOD FOR MANUFACTURING IMAGE PICKUP DEVICE**

(30) Priority: 18.02.2009 JP 2009035359
(71) Applicant: Konica Minolta Opto, Inc., Hachioji-shi Tokyo 192-8505 (JP)
(72) Inventor: TERAMOTO Tougo, Hachioji-shi Tokyo 192-8505 (JP)
(74) Representative: Henkel, Breuer & Partner
(86) International application number: PCT/JP2009/070747
(87) International publication number: WO 2010/095332

(57) **Abstract**

Provided is a lens unit (3) wherein a plurality of wafer tenses (10, 20), each of which has resin molded sections (14, 16 (24, 26)) formed on a glass substrate (12 (22)) so as to have the optical axis of the wafer lens accord with that of a light receiving sensor, are laminated. In the molded section (14) of the wafer lens (10) arranged on the outermost side of the wafer lenses (10, 20), a sloped section (14b) for having an alignment jig abut thereon is formed.

## Description

### TECHNICAL FIELD

The present invention relates to a lens unit, a method for aligning a lens unit and a sensor, an image pickup device using the same, and a method for manufacturing an image pickup device.

### BACKGROUND ART

Recently, not only manufacturing of optical lenses which are individually molded, but also a development of so-called "Wafer lenses" to which a method for manufacturing semiconductor, for example, is applied is proceeding, where the wafer lenses are formed in the way that plural minute lens-forms are simultaneously formed of resin under an imprint molding method on a glass substrate which is called as a wafer, to form a wafer lens array, and the wafer lens array is separated into individual pieces. Such the technology is useful to lenses for mobile cameras, because further more downsizing and mass-production are required for those.

Such the wafer lenses are focused from a point that small-sized and high-resolution image pickup unit including sensors can be mass-produced, where the image pickup units are provided in the way that plural wafer lens arrays are layered and jointed together for obtaining higher resolving power and the resulting body is cut and separated into individual pieces and that the pieces are attached to sensors. However, such the wafer lenses have a large problem of alignment. Especially, as for an accuracy for aligning the optical axes of minute lenses formed on respective wafer lenses, and an accuracy for aligning a wafer lens unit obtained after layering, jointing and cutting processing with respect to a sensor, each required under the condition that plural wafer lens arrays area layered, higher aligning accuracy on the order of several micrometers is required, because the lenses themselves are minute.

Such the image pickup unit for which downsizing and high resolving power are required, shows a tendency that a stop is arranged at a position closest to the object therein in view of telecentricity (telecentric characteristic). Under the condition, it takes a structure that the lens at the closest position to the object is shielded by a stop mechanism which is also provided as an opening section of a lens-holder package covering the lens unit from outside as a package member, and a stop mechanism of another member. It causes a problem that optical-axis alignment carried out by viewing the optical axis of a light-receiving sensor of a sensor unit from the upper position of the lens unit at the object side, is difficult.

As for the optical-axis alignment, there has been known a technology of an optical-axis alignment of a complex lens in which resin lenses are formed on a substrate lenses, as disclosed in Patent Literature 1. The method disclosed in the document is that a slope section for alignment is arranged on a glass member (an optical lens) to carry out centering, in order to preventing misalignment of the optical lens from the resin member (resin lens) and to control transmission decentration based on the misalignment (See paragraph s 0023 and 0076).

### CITATION LIST

### PATENT LITERATURE

Patent Literature 1: JP-A No. 2008-158200

### SUMMARY OF INVENTION

### TECHNICAL PROBLEM

However, Patent Literature 1 describes nothing about the lens but the way to align the optical axes at the object side and the subject side of a single lens, and does not disclose highly accurate alignment of a sensor and lens which is a problem caused especially in a wafer lens. Especially general wafer lenses are separated into individual pieces by a cutting (dicing) process. Therefore, when the lens which has been cut is aligned with the optical axis of a sensor, there is a high probability that the optical axes are shifted from each other depending on an accuracy of the dicing process. Because none of the problem is disclosed in Patent Literature 1, the technique of Patent Literature 1 is hardly applied to the alignment of a wafer lens and sensor.

In other words, when a wafer lens is used as a component of an electronic device such as a digital camera, a wafer lens is used with being combined with a light-receiving sensor which receives transmitted light. Therefore, even under the condition that optical axes of respective members agree with each other in a wafer lens, a wafer Jens whose optical axis is shift from the optical axis of the sensor hardly form a desired image. Accordingly, when wafer lenses for electronic devices are manufactured, an alignment of optical axes of a wafer lens and a light-receiving sensor is an important problem.

A main object of the present invention is to provide a lens unit which enables to align optical axes of a wafer lens and a light-receiving sensor, a method for aligning a lens unit and a sensor, an image pickup device and a method for manufacturing an image pickup device.

### SOLUTION TO PROBLEM

According to an embodiment of the present invention, there is provided a lens unit comprising a plurality of layered wafer lenses in each of which a resin molded section is formed on a glass substrate and a lens section is formed on a part of the resin molded section. The lens unit is **characterized in that** a first lens section is formed closest to an object side, and a resin molded section located around the first lens section forms a protrusion which protrudes more than the first lens section toward the object side.

According to another embodiment of the present invention, there is provided a lens unit comprising a plurality of layered wafer lenses in each of which a resin molded section is formed on a glass substrate and a lens section is formed on a part of the resin molded section. The lens unit is characterized by comprising in order from an object side: a first wafer lens and a second wafer lens. The first wafer lens comprises a first lens section including a convex surface which faces the object side, and formed on a part of a resin molded section, and further comprises a second lens section formed at a position across a glass substrate from the first lens section, comprising a concave surface which faces an image side, and formed on a part of a resin molded section. The second wafer lens comprises a third lens section comprising a concave surface which faces the object side, and formed on a part of a resin molded section bonded to the resin molded section on which the second lens section of the first wafer lens is formed, and further comprises a fourth lens section formed at a position across a glass substrate from the third lens section and formed on a part of a resin molded section. In the lens unit, a slope section for making contact with an alignment jig is formed on a circumference of the first lens section.

According to another embodiment of the present invention, there is provided an image pickup device comprising a lens unit. The lens unit comprises in order from an object side, a first wafer lens and a second wafer lens. The first wafer lens comprises a first lens section including a convex surface which faces the object side, and formed on a part of a resin molded section, and further comprises a second lens section formed at a position across a glass substrate from the first lens section, comprising a concave surface which faces an image side, and formed on a part of a resin molded section. The second wafer lens comprises a third lens section comprising a concave surface which faces the object side, and formed on a part of a resin molded section bonded to the resin molded section on which the second lens section of the first wafer lens is formed, and further comprises a fourth lens section formed at a position across a glass substrate from the third lens section and formed on a part of a resin molded section. The image pickup device further comprises a packaging member covering the lens unit from an outside and comprising an opening section through which light enters the first lens section; and a sensor unit in which a light-receiving sensor is arranged on one surface of a substrate with keeping a predetermined distance from the second wafer lens. The image pickup device is **characterized in that** the resin molded section around the first lens section comprises a protrusion protruding more than the first lens section in the object side and having a ring shape when viewed from the object side of the first lens section in an optical axis direction, and an edge of the opening section of the packaging member is located around the protrusion in a ring shape.

According to another embodiment of the present invention, there is provided an aligning method for making an optical axis of a lens unit comprising a plurality of layered wafer lenses coincide with a predetermined position on a light-receiving sensor for receiving light passing through the wafer lenses, wherein a resin molded section is formed on a glass substrate and a lens section is formed on a part of the resin molded section in each of the wafer lenses. The aligning method is characterized by comprising: a step of arranging the light-receiving sensor at a predetermined position, and a step of moving the lens unit so as to make the optical axis of the lens unit coincide with the predetermined position on the light-receiving sensor, with bringing an alignment jig into contact with a slope section which is formed on a molded section arranged closest to an outside among the wafer lenses and is formed on a circumference of a lens section.

According to another embodiment of the present invention, there is provided a method for manufacturing an image pickup device. The image pickup device comprises a lens unit comprising a plurality of layered wafer lenses, and a light-receiving sensor for receiving light passing through the wafer lenses, wherein a resin molded section is formed on a glass substrate and a lens section is formed on a part of the resin molded section, in each of the wafer lenses. The method is characterized by comprising: a step of preparing a first wafer lens array comprising a first glass substrate, a plurality of resin lens sections formed on the first glass substrate, and slope sections protruding with inclining outside the respective lens sections,
preparing a second wafer lens array comprising a second glass substrate and a plurality of resin lens sections formed on the second glass substrate, and
jointing and cutting the first lens array and the second lens array to form a lens unit, after layering the first lens array and the second lens array such that the slope sections are exposed outside;
a step of arranging the light-receiving sensor at a predetermined position;
a step of moving the lens unit to the light-receiving sensor which has been arranged at the predetermined position, with bringing an alignment jig in contact with the slope section of the plurality of wafer lenses; and
a step of fixing the lens unit to the sensor unit after the lens unit is moved to the predetermined position.

### ADVANTAGEOUS EFFECTS OF INVENTION

According to the present invention, by providing a structure that the periphery of the lens section arranged at the most closest position to the object side protrudes more than the lens section, a lens unit can be arranged without a packaging member under the condition that the lens section at the most closest position to the object faces downward, and the optical-axis alignment with a light-receiving sensor of a sensor unit can be carried out through a lens at the image side.

Further, because the protrusion has a structure to be arranged without being affected from an interference with a packaging member caused in the periphery of the lens section at the most closest position to the object side, the optical axis of the lens unit can be aligned to be positioned at a predetermined position with respect to the light-receiving sensor with a high accuracy from a position most closest to the object side.

Further, there is formed a slope section for coming in contact with an alignment jig, in a prescribed molded section of the wafer lens, and the arranged position of the lens unit can be fixed with the jig making into contact with the slope section. Thereby, the optical axis of the wafer lens can be made agree with a predetermined position of the light-receiving sensor, for example the optical axis of the light-receiving sensor, with high accuracy.

### BRIEF DESCRIPTION OF DRAWINGS

Fig. 1a is a sectional view showing a schematic structure of an image pickup device relating to Example 1 which is preferable to the present invention, Fig. 1b is a sectional view showing a schematic structure of an image pickup device relating to a variation of Example 1 which is preferable to the present invention, and Fig. 1c is a schematic plan view of a sensor unit in the image pickup device.
Fig. 2 is a plan view of the image pickup device of Example 1 and is a diagram showing a condition that a package is removed from the image pickup device.
Fig. 3 is a perspective view showing a schematic structure of a package relating to Example 1.
Fig. 4 is a plan view of the image pickup device of Example 1 and is a diagram showing a condition that a package is attached to the image pickup device.
Fig. 5 is a drawing for illustrating schematically a step of an optical-axis aligning method relating to Example 1.
Fig. 6 is a drawing for illustrating a step succeeding to that of Fig. 5.
Fig. 7 is a sectional view for illustrating a schematic structure of a molded section of a wafer lens relating to Example 1.
Fig. 8 is a sectional view showing a variation of Fig. 7.
Fig. 9a is a sectional view showing a schematic structure of an image pickup device relating to Example 2, which is preferable to the present invention, and Fig. 9b is a plan view schematically showing a sensor unit in the image pickup device.
Fig. 10 is a plan view showing a schematic structure of a lens unit relating to Example 2.
Fig. 11 is a bottom view showing a schematic structure of a lens unit relating to Example 2.
Fig. 12 is a diagram for illustrating schematically a step of an optical-axis aligning method relating to Example 2.
Fig. 13 is a plan view showing a schematic structure of a jig for use in Example 2.
Fig. 14 is a drawing for illustrating schematically a step of an optical-axis aligning method relating to Example 2.
Fig. 15 is a drawing for illustrating the step of Fig. 5.
Fig. 16 is a drawing for illustrating the step of Fig. 6.

### DESCRIPTION OF EMBODIMENTS

Hereinafter, preferable examples of the present invention will be described with referring to the drawings.

### EXAMPLE

### (Example 1)

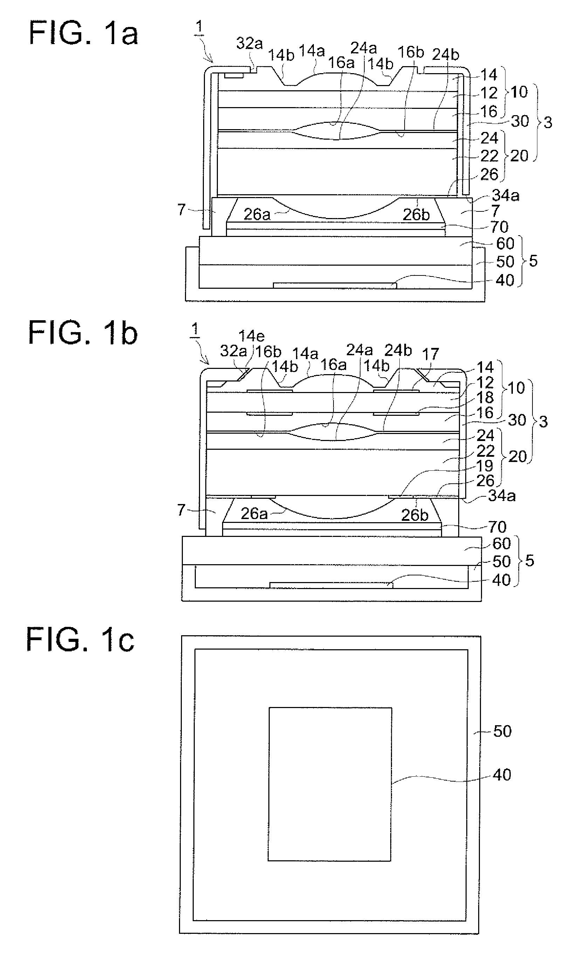

As shown in Fig. 1a, image pickup device 1 relating to Example 1 which is preferable to the present invention is mainly composed of lens unit 3, sensor unit 5 and spacer 7, and has a structure that lens unit 3 and sensor unit 5 are arranged on the both sides of spacer 7.

Lens unit 3 includes wafer lenses 10 and 20 and cover package 30. Under the condition that wafer lens 10 is layered and bonded on wafer lens 20, wafer lenses 10 and 20 are covered by cover package 30.

Wafer lens 10 includes glass substrate 12 in the shape of flat plate. Molded section 14 is formed on the top of glass substrate 12, and molded section 16 is formed on the bottom of glass substrate 12.

At the almost center of molded section 14, a convex-surface lens section 14a (hereinafter, referred as a convex lens section) in a convex shape facing the object side is formed. Slope section 14b which inclines upward in the area from convex lens section 14a toward the periphery is formed in molded section 14.

At the almost center of molded section 16, concave-surface lens section 16a (hereinafter, referred as a concave lens section) in a concave shape facing the image side is formed. In molded section 16, peripheral section 16b of concave lens section 16a is almost flat.

Wafer lens 20 also includes glass substrate 22 in the shape of a flat plate. Molded sections 24 and 26 are formed on the top and bottom of glass substrate 22, respectively.

At the almost center of molded section 24, a concave-surface lens section 24a (hereinafter, referred as a concave lens section) in a concave shape facing the object side is formed. In molded section 24, peripheral section 24b of concave lens section 24a is almost flat

At the almost center of molded section 26, convex-surface lens section 26a (hereinafter, referred as a convex lens section) in a convex shape facing the image side is formed. In molded section 26, peripheral section 26b of convex lens section 26a is almost flat.

In wafer lenses 10 and 20, molded sections 14,16,24, and 26 are parts provided by molding photo-curable resin and have optical transparency. Especially, convex lens section 14a, concave lens section 16a, concave lens section 24a and convex lens section 26a in molded sections 14,16,24 and 26 are effective lens sections which exhibit lens properties (optical properties).

Wafer lenses 10 and 20 are formed into a structure such that a flat surface of peripheral section 16b as a molded section including concave lens section 16a and a flat surface of peripheral section 24b as a molded section including concave lens section 24a are bonded with adhesive.

Herein, there has been provided an example that a lens unit is formed out oftwo wafer lenses of wafer lens 10 and 20. However, it is nothing to say that the present invention can further include another wafer lens.

An example of an image pickup device relating to a variation of Example 1 is shown in Fig. 1b. Components that are common to those in Fig. 1a are indicated by the same reference numbers as those of Fig. 1a. The first point which is different from the image pickup device of Fig. 1a is that stop members 17 and 18 for limiting an entering light flux are arranged on the object-side surface and the image-side surface of glass substrate 12 and similar stop member 19 is arranged on the image-side surface of glass substrate 22, in Fig. 1b.

The stop members 17,18 and 19 are black photoresist layers and are formed on substrates 11 and 12.

In stead of a conventional structure that a stop is arranged at a position closer to the object than the lens closest to the object by using lens package 30 or a member as a separated body, stop members are arranged, as described above, to be one body with the glass substrate at a position between the glass substrate and resin molded surfaces each of which are formed on the glass substrate and including lens sections, which allows the entire of image pickup device to be thin.

Further, it provides an advantage that those stop members do not disturb the alignment of lens unit 3 and a sensor unit that will be described later.

The second different point is that cover package 30 as a packaging member for covering lens unit 3 from outside includes an opening section at the object side which has a different shape from that of Fig.1a.

In each of Figs 1a and 1b, a protrusion which has a ring shape when viewed from the object side along the optical axis is formed around the object-side lens section of wafer lens 10, that is, the resin molded section is formed so as to protrude once toward the object side in the area at the lens-section side so as to make its highest portion higher than the lens section, and so as to be lowered, inversely, at the periphery. Especially in Fig. 1b, there is provided a protrusion in which the point that the molded section includes a slope section at an area from the lens-section side to the highest potion is the same as Fig. 1a, but the protrusion further forms a slope shape such that the diameter of the outer side becomes larger toward the image side.

When lens unit 3 formed as above is inserted to cover package 30 from the bottom of an opening side of the cover package as shown in Fig. 1b, non-lens section 14e formed around the lens section arranged closest to the object side in lens unit 3, and end section 32a forming the opening section of the cover package are fitted with each other at their tapered portions. Thereby, the center of the opening section of cover package 30 coincides with the optical axis of lens unit 3, by inserting lens unit 4 into the cover package.

The third different point is that the side surface of lens unit 3 and the side surface of spacer substrate 7 are formed by a common surface in Fig. 1b. That is provided because, when an uncut wafer lens with plural lens sections and uncut spacer substrate with plural opening sections are bonded together and are cut together, the side surfaces of the lens unit and spacer member as cut surfaces coincide to each other.

The fourth different point is that cover glass 60 of sensor unit 5 has a side surface forming the same surface with the side surface of package 50, to enclose light-receiving sensor 40 therein, in Fig. 1b. This structure is provided, similarly to the structure of the lens unit and spacer substrate described above, by jointing Package 50 and cover glass together and then, cutting them to form separated pieces.

As described above, each of Fig. 1a and 1b does not show a structure that cover package 30 covers the upper surface of the lens section, but shows a structure that a recess of the molded section formed around 14b is provided at the periphery of the protrusion in Fig. 1a and that the edge of the opening section of cover package 30 is arranged on non-lens section 14e at the periphery of the protrusion in Fig. 1b. Thereby, the periphery of the lens section is exposed from the opening section of the cover package when viewed from the object side, which allows the predetermined alignment with the optical axis of the light-receiving sensor of the sensor unit, which will be described later, without difficulty.

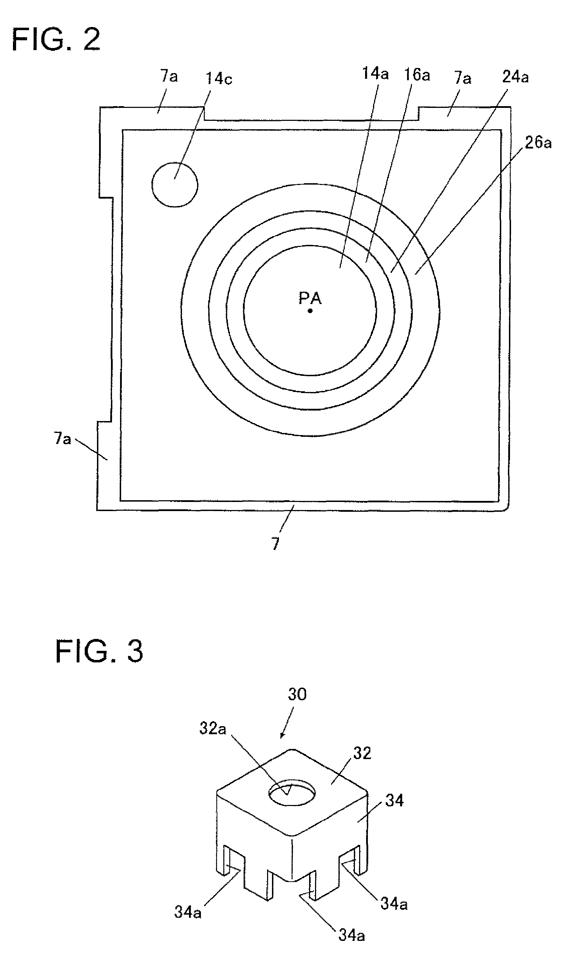

In the above wafer lenses 10 and 20, when they are viewed from the object side (the side of convex lens section 14a in Fig. 1), convex lens section 14a, concave lens section 16a, concave lens section 24a and convex lens section 26a are arranged concentrically and are vertically layered so that optical axes PA of these lens sections coincide to each other as shown in Fig. 2.

Further, as shown in Fig. 2, there can be provided decentration distinguishing mark 14c on the surface of molded section 14, for indicating the direction of decentering of convex lens section 14a relative to a cut position. When wafer lens 10 is cut to be separated in individual pieces, there is a probability that the wafer lens is cut at a cut position which has been decentered in advance in order to correspond to a sensor portion arranged to be decentered on the sensor unit. Even in the case, it is difficult to define the decentered direction in cutting, because respective lenses are minute. By indicating such decentration distinguishing mark 14c, under the situation that it is installed on the sensor unit, installation with wrong installation direction can be avoided, which is advantageous.

As shown in Fig. 3, cover package 30 has a shape of a box without the bottom plate (the lower part is opened) and is composed of one top plate section 32 and four side plate sections 34 each having a rectangular shape.

At the center of top plate section 32, round opening section 32a is formed.

On neighboring two side plate sections 34 among the four side plate sections 34, notched sections 34a are formed at three positions (those sections are not formed in the rest one rest side plate sections 34).

As shown in Fig. 1, sensor unit 5 is mainly composed of sensor 40, package 50 and cover glass 60. This description is provided with referring to a sensor unit for use in the image pickup device in Fig. 1a.

Sensor 40 is a light-receiving sensor for receiving light which has passed through lens unit 3, and can output electric signal to an external device (which is not illustrated) after carrying out photoelectric conversion for the received light.

Package 50 has a box shape with the bottom plate, and the upper part is opened. As shown in Fig. 1b, sensor 40 is arranged at the almost center of package 50.

Cover glass 60 is arranged on the top of package 50 to be a cover. Sensor 40 is tightly enclosed in a space surrounded by package 50 and cover glass 60.

As shown in Figs. 1a and 1b, spacer 7 is arranged between molded section 26 of lens unit 3 and cover glass 60 of sensor unit 5, and provides a constant interval between lens unit 3 and sensor unit 5.

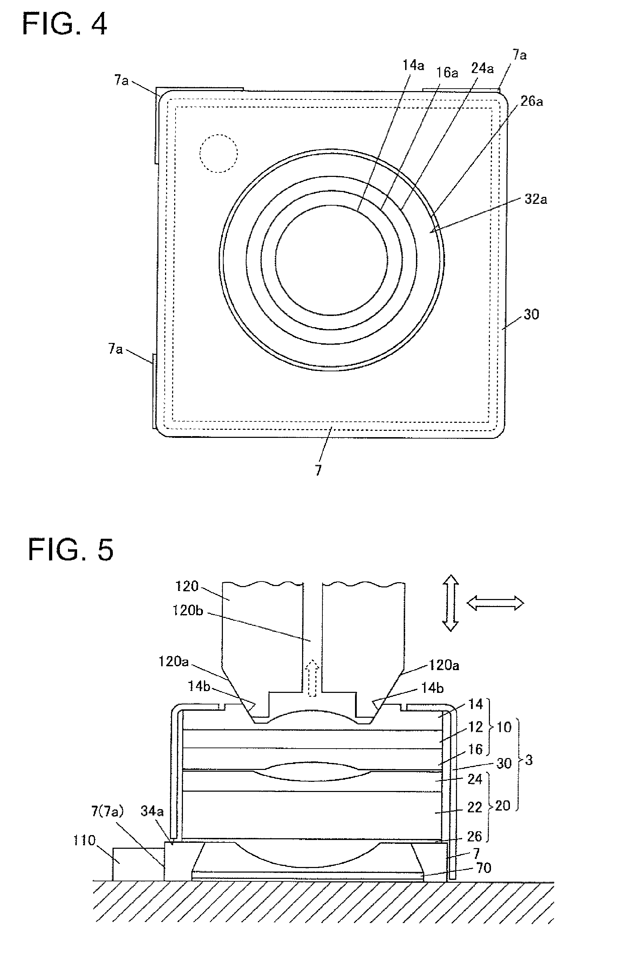

As shown in Figs. 2 and 4, spacer 7 has a shape of rectangular frame. Projections 7a are formed on neighboring two sides out of four sides and on the corner section between them. Projections 7a protrude outside cover package 30, and in detail, they protrude (are exposed) from notched sections 34a.

IR-cut filer 70 is arranged inside spacer 7. IR-cut filter 70 is arranged at the upper side of cover glass 60 to shield infrared rays to enter sensor 40.

Next, a method of aligning optical axes of lens unit 3 and sensor unit 5, which is a method of aligning optical axes of wafer lenses 10 and 20 and sensor 40 in detail, will be described.

First, as shown in Fig. 5, spacer 7 on which IR-cut filter has been attached previously is put on base 100 having a flat shape.

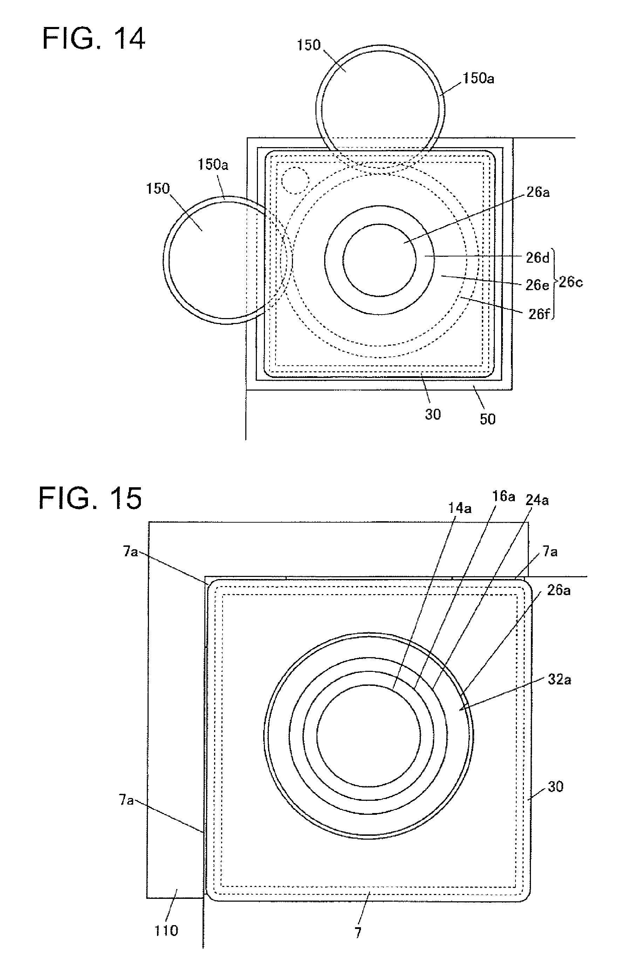

On base 100, jig 110 which is L-shaped when viewed from the object side (when viewed from the inserting side of the jig in Fig. 5) is vertically arranged and fixed. As shown in Fig. 15, respective projections 7a make contact with jig 110 to temporarily fix spacer 7 on base 110 which corresponds to jig 110.

After that, by using alignment jig 120, lens unit 3 is aligned with spacer 7 and is fixed and bonded with adhesive.

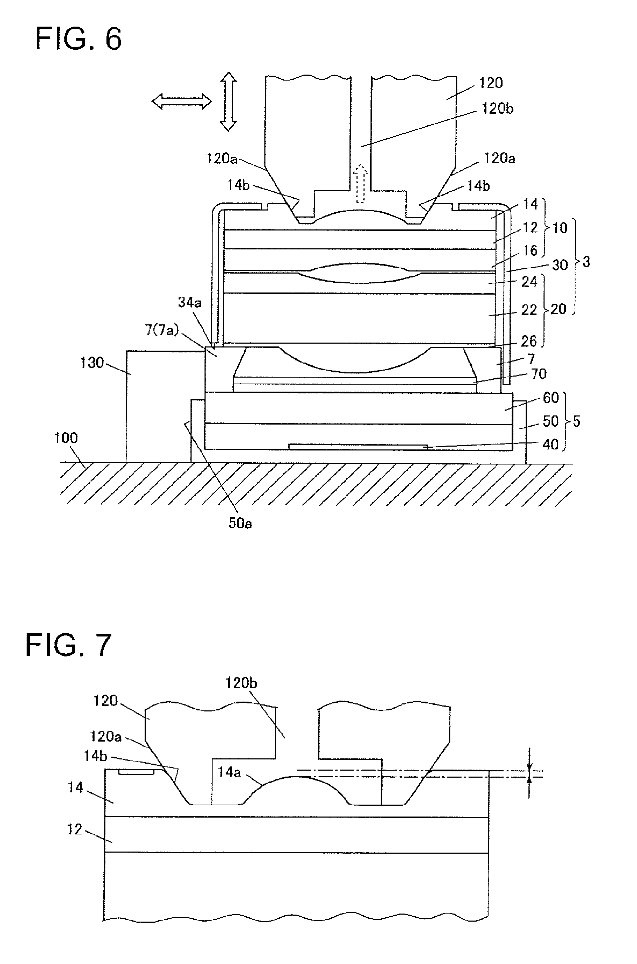

Jig 120 has a tapered shape whose tip is narrowed, and taper section 120a is formed on jig 120. At the center of jig 120, suction section 120b (vacuum hole) which can suck lens unit 3 is formed. Jig 120 is movable in the front, rear, left and right directions (in a two-dimensional plane), and up and down directions (See arrows in Figs. 5 and 6).

Herein, jig 120 is located with facing molded section 14 of lens unit 3, to bring taper section 120a into contact with slope section 14b.

Under the situation, jig 120 is moved in the front, rear, left and right directions, and up and down directions while lens unit 3 is sucked by jig 120 through suction section 120b, and lens unit 3 is moved to a predetermined position on spacer 7 by an adjusting action caused because slope section 14b of lens unit 3 is in contact with the position of jig 120. Lens unit 3 is bonded and fixed to spacer 7 at the predetermined position.

In other words, as jig 120 goes down, molded section 26 of the lens unit is gradually pressed against spacer 7. At the same time, slope section 14b of molded section 14 is finely moved so as to be completely fitted with taper section 120a of jig 120, and lens unit 3 is positioned to a proper position (predetermined position) on spacer 7, corresponding to the position where jig 120 is located.

In this case, since notched sections 34a are formed on cover package 30 of lens unit 3, spacer 7 is held with projections 7a being exposed (protruding) from notched sections 34a and being in contact with jig 110. As the result, projections 7a of spacer 7 become the reference for temporally fixing and the temporarily fixed position of spacer 7 is maintained.

When lens unit 3 is bonded and fixed to spacer 7, adhesive formed of photo-curable resin may be previously applied between them, and light may be emitted for the applied portion after the alignment of lens unit 3 is completed.

Further, in this step, lens unit 3 may be bonded and fixed to spacer 7 under the condition that cover package is detached. In this case, after lens unit 3 is bonded and fixed to spacer 7, cover package 30 may cover wafer lenses 10 and 20 from an upper position so as to make notched sections 34a of cover package 30 fitted with projections 7a of spacer 7.

After that, similarly to the step of bonding and fixing lens unit 3 to spacer 7, spacer 7 (on which lens unit 3 has been already bonded and fixed) is boded and fixed to sensor unit 5.

In detail, as shown in Fig. 6, sensor unit 5 is put on base 100.

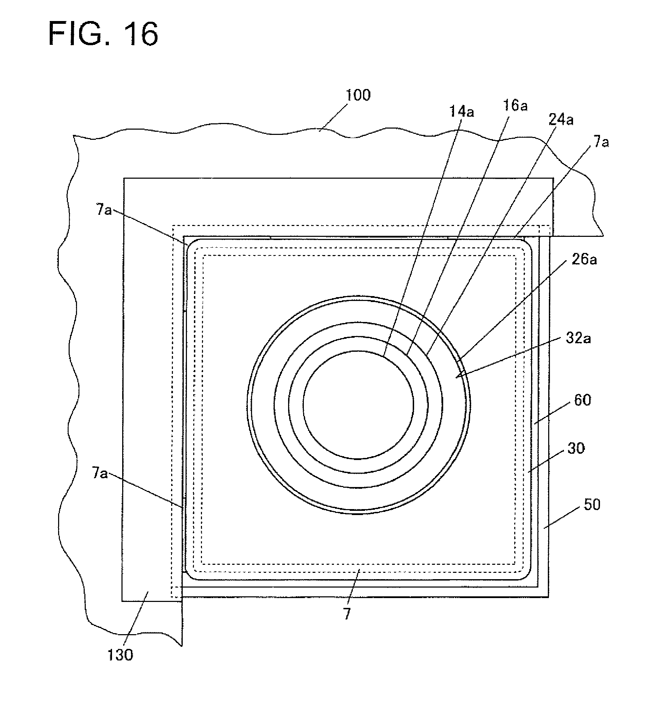

On base 100, jig 130 which is L-shaped when viewed from the object side similarly to Fig. 1c and is provided for positioning sensor unit 5 to a predetermined position on the base, is vertically arranged and fixed (in Fig. 6, a part of the jig is illustrated). As shown in Fig. 16, side surfaces (two neighboring side surfaces 50a) of package 50 in sensor unit 5 are brought into contact with jig 130, and sensor unit 5 is fixed temporarily at predetermined position C on base 100 corresponding to jig 130.

Under the condition, by using alignment jig 120 again, spacer 7 is aligned with sensor unit 5 to be bonded and fixed together.

Herein, jig 120 is moved right and left, backward and forward directions, and up and down directions, while lens unit 3 is sucked by jig 120 through suction section 120b with bringing taper section 120a of jig 120 into contact with slope section 14b. Thereby, lens unit 3 is moved to a predetermined position corresponding to the position of sensor unit 5 (sensor 40), and spacer 7 is bonded and fixed on sensor unit 5 at the position.

Similarly to the alignment of lens unit 3 and spacer 7 which has been described above, as jig 120 goes down, spacer 7 is gradually pressed against cover glass 60. At the same time, slope section 14b of molded section 14 is finely moved so as to be completely fitted with taper section 120a of jig 120, and lens unit 3 is positioned at a proper position (predetermined position) corresponding to a position of where spacer 7 is arranged. Thereby, the optical axes of wafer lenses 10 and 20 in lens unit 3 coincide with the optical axis of sensor 40 of sensor unit 5.

This description has been illustrated the alignment of the optical axis of the sensor and wafer lenses 10 and 20 of lens unit 30. However, an embodiment is not limited to that the optical axes of wafer lenses 10 and 20 is aligned with the optical axis of sensor. In other words, depending on the specifications of an image pickup device, it can be an embodiment that the optical axes of wafer lenses 10 and 20 is positioned at a predetermined position which is shifted from the optical axis of the sensor.

Herein, "the optical axis of the sensor" indicates the diagonal center of an effective pixel area which can be used actually by an optical pickup device for shooting, out of a pixel area of the light-receiving sensor.

Also in this case (the case that spacer 7 and sensor unit 5 are bonded together), adhesive made of photo-curable resin may be applied on an area between them in advance and light may be emitted toward the area after the positioning of lens unit 3 is completed.

As the result, the optical axes of wafer lenses 10 and 20 in lens unit 3 can be aligned with the optical axis of sensor 30 of sensor unit 5 through spacer 7.

Herein, lens unit 3 has been aligned with sensor unit 5 by using jig 130 and jig 120. Alternatively, the alignment may be carried out with the following method.

That is, lens unit 3 may be moved with jig 120 to a position where every projections 7a of spacer 7 come in contact with jig 130, and jig 120 may goes down from the position to make spacer 7 bonded and fixed on sensor unit 5.

In this case, lens unit 3 is aligned with sensor unit 5 with jig 130.

Herein, the example that projections 7a of spacer 7 is brought into contact with jig 130 has been shown, but the portion where projections 7a of the spacer are in contact with may be formed of a jig which is a different body from jig 130.

In the above Example 1, slope section 14b for making contact with alignment jig 120 is formed on molded section 14 of wafer lens 10 which is arranged at the position closest to the object side among wafer lenses 10 and 20 of wafer lens 3. The arrangement position of lens unit 3 is defined while jig 120 is brought into contact with slope section 14b by using slope section 14b as the reference.

Therefore, the optical axes of wafer lenses 10 and 20 can be made coincide with the optical axis of sensor 20 regardless of the accuracy of dicing carried out in the manufacturing of wafer lenses 10 and 20, which is different from the situation that the optical axes of wafer lenses 10 and 20 are made coincide with the optical axis of sensor 40 by using the cut surfaces (side end surfaces) of wafer lenses 10 and 20 as the reference.

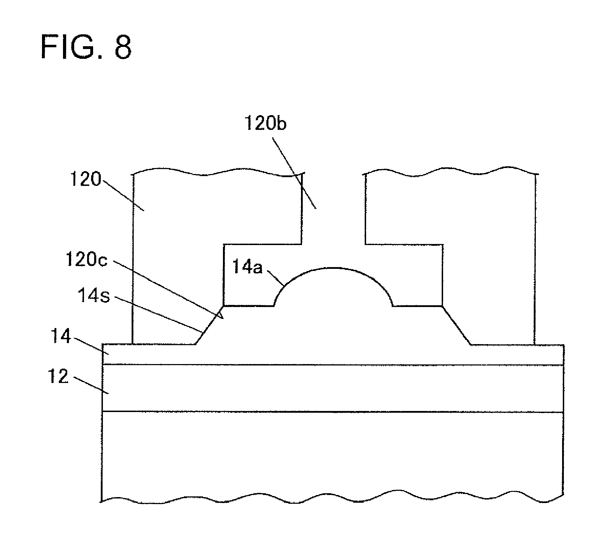

In molded section 14 relating to the present Example 1, as shown in Fig. 7, slope section 14b inclines upward at an area from convex lens section 14a toward the circumference section, and the highest portion of slope section 14b is higher than convex lens section 14a. Alternatively, there can be formed molded section 14 as shown in Fig. 8. In molded section 14 in Fig. 8, slope section 14s inclines downward at an area from convex lens section 14a toward the circumference section, and slope section 14s becomes lower than convex lens section 14a.

When constructions of Figs. 7 and 8 are compared with each other, it is preferable that the construction of Fig. 7 is employed. In molded section 14 in Fig. 8, the height (thickness) of resin of moulded section 14 is obtained by the height of slope section 14s and the height of convex lens section 14a. In molded section 14 in Fig. 7, the height (thickness) of resin ofmolded section 14 is obtained by any one of the height of slope section 14b and the height of convex lens section 14a.

Therefore, the construction in Fig. 7 is advantageous in view of reducing the thickness of resin ofmolded section 14. When the thickness of the resin is reduced, the shrinkage amount on curing of resin caused in the molding process can be reduced, which can form an effective lens section with excellent moldability and high accuracy.

Furthermore, in the construction of Fig. 8, convex lens section 14a is exposed and protrudes on the same level of the slope section, and scratches and damages can easily be caused on convex lens section 14a when it is handled. However, in the construction in Fig. 7, convex lens section 14a can be covered by using the height of slope section 14b and the generation of cracks and damages on convex lens section 14a can be avoided effectively, even when it is handled.

### (Example 2)

Example 2 is mainly different from Example 1 under the following point, and the other points are same as Example 1.

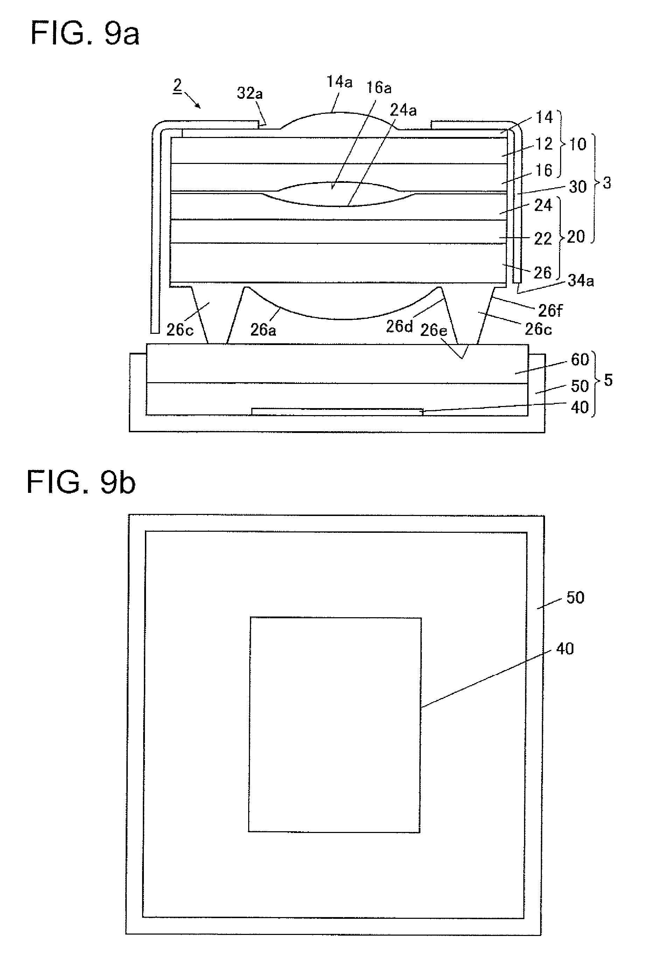

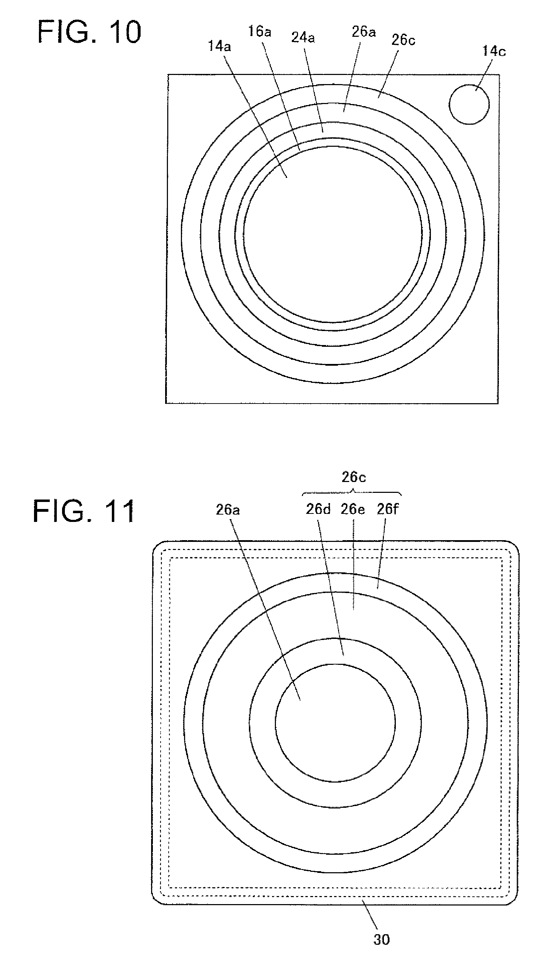

As shown in Figs. 9 and 10, in image pickup device 2 relating to Example 2, there are not arranged slope section 24b in molded section 14 of wafer lens 10, and spacer 7 (including IR-cut filter). As an alternative component spacer section 26c is formed in molded section 26 of wafer lens 20.

As shown in Figs. 9 and 11, spacer section 26c is composed of inner slope section 26d, bonding section 26e and outer slope section 26f, and spacer section 26c is higher than the thickness of convex lens section 26a.

Inner slope section 26d inclines downward at an area from convex lens section 26a toward the outer circumference. Bonding section 26e is flat and becomes a bonding surface to be bonded to cover glass 60 of sensor unit 5. Outer slope section 26f inclines upward at an area from bonding section 26e toward the outer circumference.

Next, an optical-axis aligning method oflens unit 3 and sensor unit 5 relating to Example 2 will be described.

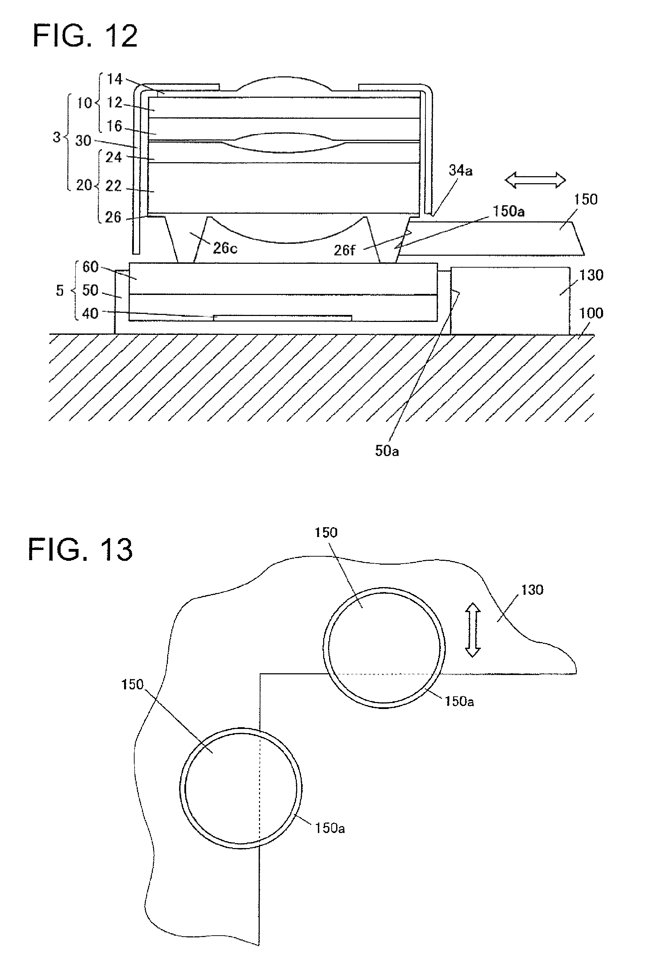

For a start, as shown in Fig. 12, side surfaces (two side surfaces 50a) of package 50 of sensor unit 5 is brought into contact with jig 130, respectively, and sensor unit 5 is fixed at predetermined position C temporarily, similarly to Example 1.

Under this condition, lens unit 3 is aligned with sensor unit 5 with alignment jig 150, and they are bonded and fixed together.

As shown in Fig. 13,jig 150 is a member having a round shape when viewed from the object side similarly to Fig. 1c, and side surface 150a inclines so as to be capable of coming in contact with outer slope section 26fin molded section 26 of wafer lens 20.

In this example, lens unit 3 is put on sensor unit 5 which has been fixed temporarily. Spacer section 26c in molded section 26 of lens unit 3 is pressed toward jig 150, and lens unit 3 is bonded and fixed to sensor unit 5 at that position.

In this case, as shown in Fig. 14, lens unit 3 is positioned at a proper position (predetermined position) on sensor unit 5 with jig 150, while outer slope section 26f of spacer member 26c is in contact with side surface 150a of jig 150. Thereby, the optical axes of wafer lenses 10 and 20 of lens unit 3 and the optical axis of sensor 40 of sensor unit 5 coincide with each other.

When lens unit 3 and sensor unit 5 are bonded together, adhesive made of photo-curable resin may be applied on an area between 26e of molded section 26 and cover glass 60 in advance, and light may be emitted toward the applied area after the alignment of leas unit 3 is completed.

As the result, the optical axes of wafer lenses 10 and 20 of lens unit 3 and the optical axis of sensor 40 of sensor unit 5 can coincide with each other.

In lens unit 3 in Example 1, wafer lens 20 maybe omitted and lens unit 3 may be composed of wafer lens 10 and cover package 30. In lens unit 3 in Example 2, wafer lens 10 may be omitted and lens unit 3 may be composed of wafer lens 20 and cover package 30.

Herein, an optical-axis alignment of the optical axis of a sensor and the optical axes of wafer lenses 10 and 20 has been shown, but the optical axes of wafer lenses 10 and 20 is not limited to being aligned with the optical axis of the sensor. In other words, depending on the specifications of an image pickup device, the optical axes of wafer lenses 10 and 20 may be aligned with a predetermined position which is displaced from the optical axis of the sensor.

### REFERENCE SIGNS LIST

- 1, 2: Image pickup device
- 3: Lens unit
- 5: Sensor unit
- 7: Spacer
- 7a: Projection
- 10: Wafer lens
- 12: Glass substrate
- 14, 16: Molded section
- 14a: Convex lens section
- 14b: Slope section
- 14c: Decentration distinguishing mark
- 14s: Slope section
- 16a: Concave lens section
- 16b: Peripheral section
- 20: Wafer lens
- 22: Glass substrate
- 24, 26: Molded section
- 24a: Concave lens section
- 24b: Peripheral section
- 26a: Convex lens section
- 26b: Peripheral section
- 26c: Spacer section
- 26d: Inner slope section
- 26e: Bonding section
- 26f: Outer slope section
- 30: Package
- 32: Top plate section
- 32a: Opening section
- 34: Side plate section
- 34a: Notched section
- 40: Sensor
- 50: Package
- 60: Cover glass
- 70: IR-cut filter
- 100: Base
- 110, 130: Jig
- 120: Jig (for alignment)
- 120a: Tapered section
- 124b: Suction section
- 150: Jig (for alignment)
- 150a: Side surface
- PA: Optical axis

## Claims

1. A lens unit comprising a plurality of layered wafer lenses in each of which a resin molded section is formed on a glass substrate and a lens section is formed on a part of the resin molded section, the lens unit **characterized in that**
a first lens section is formed closest to an object side, and
a resin molded section located around the first lens sections forms a protrusion which protrudes more than the first lens section toward the object side.

2. The lens unit of claim 1 **characterized by** comprising in order from the object side:
a first wafer lens comprising
the first lens section including a convex surface which faces the object side, and formed on a part of a resin molded section, and
a second lens section formed at a position across a glass substrate from the first lens section, comprising a concave surface which faces an image side, and formed on a part of a resin molded section; and
a second wafer lens comprising
a third lens section comprising a concave surface which faces the object side, and formed on a part of a resin molded section bonded to the resin molded section on which the second lens section of the first wafer lens is formed, and
a fourth lens section fanned at a position across a glass substrate from the third lens section and formed on a part of a resin molded section.

3. The lens unit of claim 1 or 2 **characterized in that**
the protrusion is formed in a ring shape when viewed from the object side of the first lens section along an optical axis.

4. The lens unit of claim 3 **characterized in that**
the protrusion comprises a first slope section formed such that a diameter of a side surface of the protrusion facing the first lens section increases toward the object side.

5. The lens unit of claim 3 **characterized in that**
the protrusion comprises a second slope section formed such that a diameter of a side surface of the protrusion opposite to the first slope section increases toward an image side.

6. The lens unit of any one of claims I to 5, **characterized in that**
the resin molded section on which the first lens section is formed, is formed on a surface of a glass substrate, and
a stop member is formed on the surface of the glass substrate to be located between the surface of the glass substrate and the resin molded section.

7. A lens unit comprising a plurality of layered wafer lenses in each of which a resin molded section is formed on a glass substrate and a lens section is formed on a part of the resin molded section, the lens unit **characterized by** comprising in order from an object side:
a first wafer lens comprising
a first lens section including a convex surface which faces the object side, and formed on a part of a resin molded section, and
a second lens section formed at a position across a glass substrate from the first lens section, comprising a concave surface which faces an image side, and forked on a part of a resin molded section; and
a second wafer lens comprising
a third lens section comprising a concave surface which faces the object side, and forme on a part of a resin molded section bonded to the resin molded section on which the second lens section of the first wafer lens is formed, and
a fourth lens section formed at a position across a glass substrate from the third lens section and formed on a part of a resin molded section,
wherein a slope section for making contact with an alignment jig is formed on a circumference of the first lens section.

8. The lens unit of claim 7 **characterized in that**
a height of the slope section increases in a direction from the lens section to a periphery.

9. The lens unit of claim 7 **characterized in that**
the lens section has a convex shape and
a highest portion of the slope section is higher than the lens section.

10. An image pickup device comprising:
a lens unit comprising in order from an object side,
a first wafer lens comprising
a first lens section including a convex surface which faces the object side, and formed on a part of a resin molded section, and
a second lens section formed at a position across a glass substrate from the first lens section, comprising a concave surface which faces an image side, and formed on a part of a resin molded section;
a second wafer lens comprising
a third lens section comprising a concave surface which faces the object side, and formed on a part of a resin molded section bonded to the resin molded section on which the second lens section of the first wafer lens is formed, and
a fourth lens section formed at a position across a glass substrate from the third lens section and formed on a part of a resin molded section;
a packaging member covering the lens unit from an outside and comprising an opening section through which light enters the first lens section; and
a sensor unit in which a light-receiving sensor is arranged on one surfaces of a substrate with keeping a predetermined distance from the second wafer lens,
the image pickup device **characterized in that**
the resin molded section around the first lens section comprises a protrusion protruding more than the first lens section in the object side and having a ring shape when viewed from the object side of the first lens section in an optical axis direction, and
an edge of the opening section of the packaging member is located around the protrusion in a ring shape.

11. The image pickup device of claim 10 **characterized in that**
the protrusion comprises a first slope section formed such that a diameter of a side surface of the protrusion facing the first lens section increases toward the object side.

12. The image pickup device of claim 10 or 11 **characterized in that**
the protrusion comprises a second slope section formed such that a diameter of a side surface of the protrusion opposite to the first slope section increases toward an image side, and
the opening section of the packaging member comprises a sloped opening section fitting with the second slope section.

13. The image pickup device of any one of claims 10 to 12 **characterized in that**
the resin molded section on which the first lens section is formed, is formed on a surface of a glass substrate, and
a stop member is formed on the surface of the glass substrate to be located between the surface of the glass substrate and the resin molded section.

14. The image pickup device of any one of claims 10 to 13 **characterized in that**
an external form of the lens unit has a rectangular shape when viewed along the optical axis direction.

15. The image pickup device of any one of claims 10 to 14 **characterized in that**
an optical axis of the lens unit and an optical axis of the light-receiving sensor of the sensor unit coincide with each other.

16. The image pickup device of any one of claims 10 to 15 **characterized by** further comprising;
a spacer substrate arranged at a fourth-lens-section side of the second wafer lens, comprising an opening section at a position corresponding to the first through fourth lens sections, and formed of glass,
wherein the sensor unit comprises a cover members connected with the other end section of the spacer substrate and formed of glass, and
the light-receiving sensor is arranged on one surface of the substrate with keeping a predetermined distance from the packaging member.

17. An aligning method for making an optical axis of a lens unit comprising a plurality of layered wafer lenses coincide with a predetermined position on a light-receiving sensor for receiving light passing through the wafer lenses, wherein a resin molded section is formed on a glass substrate and a lens section is formed on a part of the resin molded section in each of the wafer lenses,
the aligning method **characterized by** comprising:
a step of arranging the light-receiving sensor at a predetermined position, and
a step of moving the lens unit so as to make the optical axis of the lens unit coincide with the predetermine position on the light-receiving sensor, with bringing an alignment jig into contact with a slope section which is formed on a molded section arranged closest to an outside among the wafer lenses and is formed on a circumference of a lens section.

18. The aligning method of claim 17 **characterized in that**
after the step of moving the lens unit to the predetermined position, with bringing the alignment jig into contact with the slope section,
the lens unit is moved in an optical axis direction so that a distance to the light-receiving sensor which has been arranged at the predetermined position becomes a predetermined distance.

19. The alignment method of claim 18 **characterized by** further comprising before the step of arranging the light-receiving sensor at the predetermined position:
a step of temporarily fixing a spacer for proving a constant distance between the lens unit and the light-receiving sensor; and
a step of moving the lens unit to the spacer which has been fixed, with bringing the alignment jig into contact with the slope section, and of bonding the lens unit and the spacer together.

20. The alignment method of claim 19 **characterized by** comprising:
a step ofmoving the lens unit in the optical axis direction so that the distance to the light-receiving sensor becomes the predetermined distance, after the lens unit is moved to the predetermined position with the alignment jig coming into contact with the slope section; and
a step of bonding the lens unit and the spacer together, after the step of arranging the lens unit so that the distance to the light-receiving sensor becomes the predetermined distance.

21. The alignment method of claim 19 or 20 **characterized in that**
the lens unit comprises a cover package for covering the plurality of wafer lenses,
a notched section is formed on the cover package, and
in the step of bonding the lens unit and the spacer together, the spacer is kept at a temporarily fixed position by using a portion of the spacer exposed through the notched section of the cover packages as a reference.

22. The alignment method of any one of claims 17 to 21 **characterized in that**
the lens unit is provided by layering and jointing a plurality of wafer lens arrays in each of which a plurality of molded sections are formed on a glass substrate, and by cutting the wafer lens arrays into separated pieces.

23. The alignment method of any one of claims 17 to 22 **characterized in that**
the lens unit is aligned with the light-receiving sensor such that the optical axis of the lens unit coincide with the optical axis of the light-receiving sensor.

24. A method for manufacturing an image pickup device, the image pickup device comprising a lens unit comprising a plurality of layered wafer lenses, and
a light-receiving sensor for receiving light passing through the wafer lenses, wherein a resin molded section is formed on a glass substrate and a lens section is formed on a part of the resin molded section, in each of the wafer lenses,
the method **characterized by** comprising:
a step of preparing a first wafer lens array comprising a first glass substrate, a plurality af resin lens sections formed on the first glass substrate, and slope sections protruding with inclining outside the respective lens sections,
preparing a second wafer lens array comprising a second glass substrate and a plurality of resin lens sections fanned on the second glass substrate, and
jointing and cutting the first lens array and the second lens array to form a lens unit, after layering the first lens array and the second lens array such that the slope sections are exposed outside;
a step of arranging the light-receiving sensor at a predetermined position;
a step of moving the lens unit to the light-receiving sensor which has been arranged at the predetermined position, with bringing an alignment jig in contact with the slope section of the plurality of wafer lenses; and
a step of fixing the lens unit to the sensor unit after the lens unit is moved to the predetermined position.
